Europäisches Patentamt

European Patent Office

Office européen des brevets

(19)

(11) **EP 0 710 844 B1**

(12) **EUROPEAN PATENT SPECIFICATION**

(45) Date of publication and mention
of the grant of the patent:
**22.05.2002 Bulletin 2002/21**

(51) Int Cl.7: **G01R 15/14**, G01R 15/18

(21) Application number: **95115801.3**

(22) Date of filing: **06.10.1995**

(54) **Method of measuring an alternating current, measurement detector for measurement of alternating current, and use of said detector in a kWh meter**

Verfahren zur Messung von Wechselstrom, Messdetektor und seine Verwendung in einem kWh-Zähler

Méthode pour mesurer du courant alternatif, détecteur de mesure pour courant alternatif et utilisation de ce détecteur dans un compteur électrique

(84) Designated Contracting States:
**AT BE CH DE DK ES FR GB GR IE IT LI LU MC NL PT SE**

(30) Priority: **07.11.1994 FI 945232**

(43) Date of publication of application:
**08.05.1996 Bulletin 1996/19**

(73) Proprietor: **ENERMET OY**
**SF-40420 Jyskä (FI)**

(72) Inventor: **Seppä, Heikki**
**FIN-00370 Helsinki (FI)**

(74) Representative: **Pellmann, Hans-Bernd, Dipl.-Ing.**
**Patentanwaltsbüro**
**Tiedtke-Bühling-Kinne & Partner**
**Bavariaring 4-6**
**80336 München (DE)**

(56) References cited:
**DE-A- 4 125 087**

- **IEEE TRANS. ON INSTRUM. & MEASUREMENT, vol. 38, no. 1, February 1989, NEW YORK,NY, US, pages 22-26, XP000105807 R.L.KLEINBERG ET AL.: "Noncontacting Electrical Conductivity Sensor for Remote, Hostile Environments"**
- **CRYOGENICS, vol. 32, no. 10, 1992, GUILDFORD, SURREY, GB, pages 881-884, XP000319817 S.KNAPPE ET AL.: "A planar YBa2CU3O7 gradiometer at 77K"**

## Description

The invention concerns a method for measurement of alternating current.

Further, the invention concerns an integrated current detector for measurement of alternating current.

In a kWh meter, measurement of current requires high dynamism (10 mA...200 A), good resistance to interference, good linearity, and the detector must tolerate any direct current that may be present in a conductor. Measurement of current is most commonly based on resistance, which converts the current to voltage, on a current transformer with an iron or ferrite core, on an induction phenomenon, in which the primary current induces a voltage in the secondary coil, on magnetic detectors (such as a Hall detector or a magneto-resistive detector), or, in some cases, on an optical fibre that senses the magnetic field. In all the detectors, except that based on resistance, the measurement is, in one way or another, based on utilization of the magnetic field produced by the current. The different methods are associated with good and bad features. A traditional current transformer is spacious and does not tolerate direct current, so that, in modern kWh meters, its use is being abandoned.

Document DE 41 25 087 A1 discloses a method and a device for measuring magnetic fields. In detail, the device comprises a supraconductive loop arrangement including a DC SQUID (Supercondution QUantum Interference Devices) composing a gradiometer. The gradiometer includes two groups of adjacently disposed partial loops connected in parallel. In order to suppress noise of higher frequency, a noise suppressing circuit having a supraconductive shield loop is provided in parallel to the partial loops. The impedance and the inductance of the noise suppressing circuit is chosen such that an attenuation of the field signals to be detected is largely prevented.

The object of the present invention is to provide an improvement over the prior-art methods for measurement of alternating current and to provide a measurement detector meant for measurement of alternating current and excellently suitable for use in kWh meters.

This object is achieved by a method of measuring an alternating current as defined in claim 1, and by an integrated current detector for measurement of alternating current as defined in claim 5.

Further advantageous developments are set out in the dependent claims.

In the present patent application, the definitions "in direct vicinity of the current conductor system" and "in direct vicinity of the outputs of the gradiometer" mean a distance that is proportional to the sizes of the gradiometer and of a portion of the conductor. The size of the gradiometer can be of an order of 5...10 mm, and the size of the cross-section of a portion of the conductor may be of an order of 1...5 mm. Thus, direct vicinity means a distance that is smaller than, or equal to, the largest dimension of the gradiometer.

The pre-amplifier may be, for example, integrated on the same silicon chip as the gradiometer, or the pre-amplifier may be placed in a separate circuit, installed, for example, by means of the flip-chip technique on the gradiometer.

The gradiometer can be accomplished by connecting the coils and by using one common pre-amplifier, or by amplifying the signals of the coils separately by means of pre-amplifiers of their own and by interconnecting the amplified signals. The gradiometer may also be a combination of the wirings described above.

In the present invention, a gradiometer of the $n^{th}$ order can be grown onto a base, such as, for example, silicon. If high currents and voltages are concerned, the gradiometer is a gradiometer of either first or second order. When low currents and voltages are concerned, the gradiometer may perhaps be a gradiometer of third, fourth, of fifth or even sixth order. Of course, when the order becomes higher, the system becomes more complicated.

The present-day technique of manufacture of masks permits an integration of gradiometer coils so that the attenuation, for example, with a homogeneous field can be made very high (higher than 1000). The manufacture of masks is based on a laser exposer, whose location is determined by means of a laser interferometer, which permits an inaccuracy of location below 0.5 μm. By means of masks it is possible to produce line widths even of an order of 1 μm, but the width of the ultimate conductor is determined in the process of manufacture. A present, a realistic width of a conductor is about 1...3 μm.

Since the detector includes a gradiometer, it is insensitive to a homogeneous magnetic field. If a gradiometer of the second order is used, the detector is also insensitive to a field that changes linearly as a function of place. In other words, the current detector is not disturbed even by an intensive field of interference. Since the detector is based on the induction phenomenon, a DC-magnetic field arising in a direct current in the current conductor or an outside DC-field does not affect the operation of the detector. If the attenuation of interference in the detector is not sufficient, it is possible to install a magnetic shield around the detector to provide additional attenuation.

The coils in a gradiometer of the second order may consist of three coils whose areas are equal but in which the number of windings in the middle coil is twice as high as the number of windings in the lateral coils. In such a case, the number of windings in the middle coil is preferably in a range of 10...1000. The areas of the coils are preferably in the range of 1...30 $mm^2$.

The invention will be described in detail with reference to some preferred embodiments of the invention shown in the figures in the accompanying drawing, the invention being, yet, not supposed to be confined to said embodiments alone.

Figure 1 illustrates a prior-art static kWh meter as a block diagram.

Figure 2 shows a prior-art static kWh meter as a block diagram, wherein the switching arrangement of the multiplier circuit is shown in more detail in respect of one phase.

Figure 3 is a schematic illustration of a mask on which a gradiometer of the second order has been formed, viewed from above.

Figure 4 is an axonometric view of a preferred embodiment of a current conductor, which is suitable for use with a gradiometer of the second order as shown in Fig. 3.

Figure 5 is a graphic illustration of the form of the magnetic field of the current conductor shown in Fig. 4.

Figure 6 is an axonometric view of a preferred embodiment of the measurement detector in accordance with the invention.

Figure 7 is a graphic illustration of the output voltage of the measurement detector as shown in Fig. 6.

Figure 8a is a schematic illustration of the use of a measurement detector in accordance with the invention for measurement of three-phase current, viewed from above.

Figure 8b is a side view of the measurement detector arrangement shown in Fig. 8a.

Figure 9 is a schematic illustration of a simplified circuit diagram of a current measurement unit of a three-phase kWh meter.

Fig. 10a is a schematic illustration of a measurement wiring when a current detector in accordance with the invention is used in a 1-phase kWh meter.

Figure 10b is a schematic illustration of a second measurement wiring when a current detector in accordance with the invention is used in a 1-phase kWh meter.

Figure 11a is a schematic illustration of a measurement wiring when a current detector in accordance with the invention is used in a 3-phase kWh meter.

Figure 11b is a schematic illustration of a second measurement wiring when a current detector in accordance with the invention is used in a 3-phase kWh meter.

Figure 11c is a schematic illustration of a third measurement wiring when a current detector in accordance with the invention is used in a 3-phase kWh meter.

Figure 12 shows a schematic block diagram of an application of use of a measurement detector in accordance with the invention in a kWh meter.

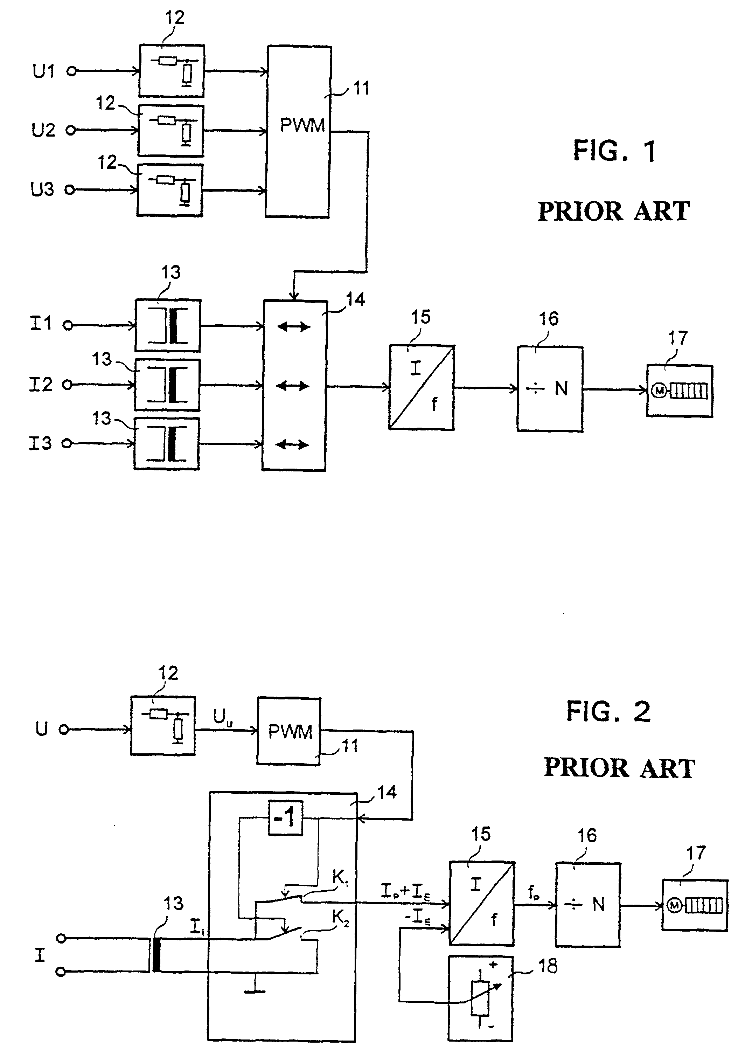

The prior-art static kWh meter shown in Figs. 1 and 2 comprises voltage dividers 12 and current measurement transformers 13, which are connected to the wires of the electricity network so as to generate measurement signals $U_u$, $I_i$ proportional to the voltage U and to the current I, and a multiplier circuit 11,14 to form a pulse-width/pulse-height modulated signal which represents the product of the measurement signals. By means of the square waves received from the pulse-width modulator 11, the analog connectors $K_1$ and $K_2$ placed in the secondary circuit of the current measurement transformers 13 are controlled, and from the outputs of said connectors $K_1$ and $K_2$ pulses are received, whose height is proportional to the current flowing in the measurement current circuit and whose width is still modulated by the mains voltage. The pulses are filtered, whereby a direct current $I_p$ proportional to the power is obtained, which direct current is fed to the current-frequency converter 15.

Thus, from the output of the current-frequency converter 15, a pulse frequency $f_p$ is obtained, which is proportional to the direct current $I_p$, i.e. to the power, which pulse frequency $f_p$ is passed through the divider unit 16 to the stepping motor that operates the counter device 17 of the meter. The counter device 17 integrates the power, i.e. displays the energy consumed.

By the effect of the switching pulses, an extra DC component $I_E$ is produced in the measurement circuit, which component deteriorates the accuracy of measurement in particular when the current to be measured is low. In the solution of Fig. 2, the DC component $I_E$ is compensated for by an external regulation member 18, from which a current $-I_E$ of opposite sign and of equal magnitude is fed to the current-frequency converter 15.

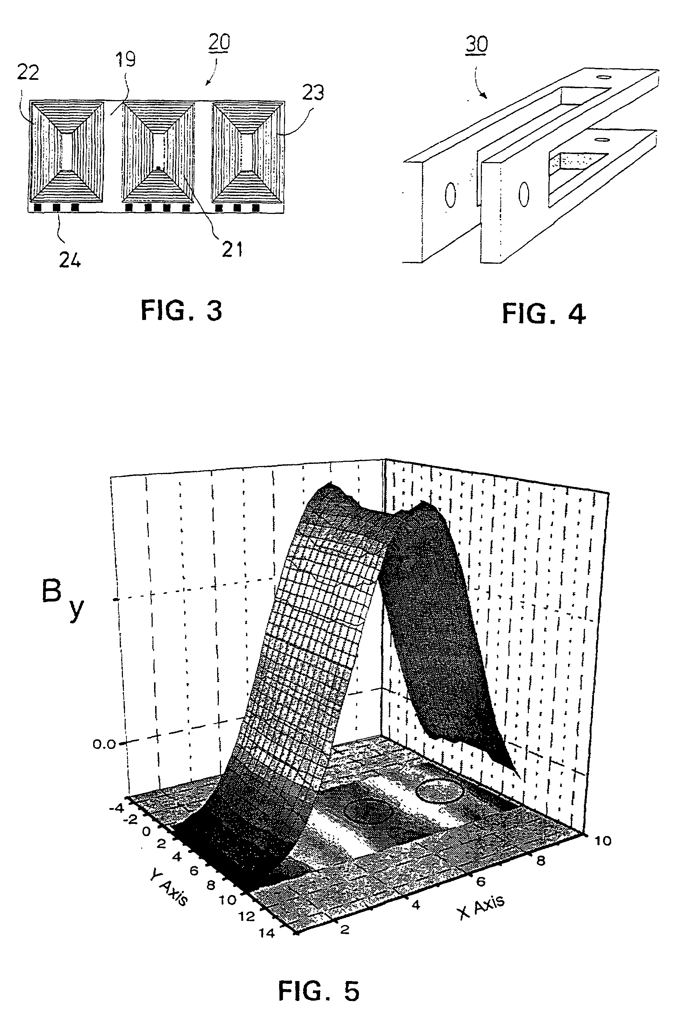

Fig. 3 illustrates a mode of manufacture of a gradiometer of the second order, which is sensitive to a magnetic field of parabolic form only. The gradiometer consists of a narrow (1...5 µm) and thin (0.1...2 µm) conductor, which circulates as spiral-shaped in one or several planes and forms an antenna construction. The gradiometer 20a of the second order, which is made of a mask 20, may consist, for example, of three coils 21,22 and 23, in which the areas of all of the coils are equal, but the number of windings in the middle coil 21 is twice as high as the number of windings in the lateral coils 22 and 23. The coils are connected so that the homogeneous magnetic field that changes in a linear way as a function of place does not induce a voltage in the output of the gradiometer. In Fig. 3, the base, for example a silicon substrate, is denoted with the reference numeral 19 and the output terminals with the reference numeral 24.

A gradiometer of the first order may be composed of two coils whose centre points are placed at a distance of about 2...5 mm from one another. The size of the coils measured from the outer edge is about (1...4 mm) x (1...4 mm), and the number of windings is 100...300.

If the current conductor is shaped appropriately, it is possible to produce distributions of magnetic field of different shapes in its direct vicinity. For example, if a rectangular conductor is split at both ends, a conductor construction 30 as shown in Fig. 4 is obtained, which produces a parabolic distribution of magnetic field as shown in Fig. 5 in the middle of the conductor 30. If a gradiometer 20a of the second order is installed in the middle of such a conductor 30, the current flowing in the conductor 30 induces a voltage in it. With a suitable choice of the shape of the conductor and the shape of the gradiometer, a situation is formed in which the place of the gradiometer has no significant effect on the output of the gradiometer. In other words, if the conductor is shaped appropriately and if the gradiometer is composed of a number of coils, a current detector is provided whose place does not affect the output voltage of the detector. In this way, it is possible to eliminate the effect of temperature or ageing on inaccuracy of measurement. Since the conductor is made of a metal, its thermal expansion coefficient is low. The gradiometer can, for example, be cast in the interior of the conductor so that it remains reasonably well in the "middle" of the current conductor.

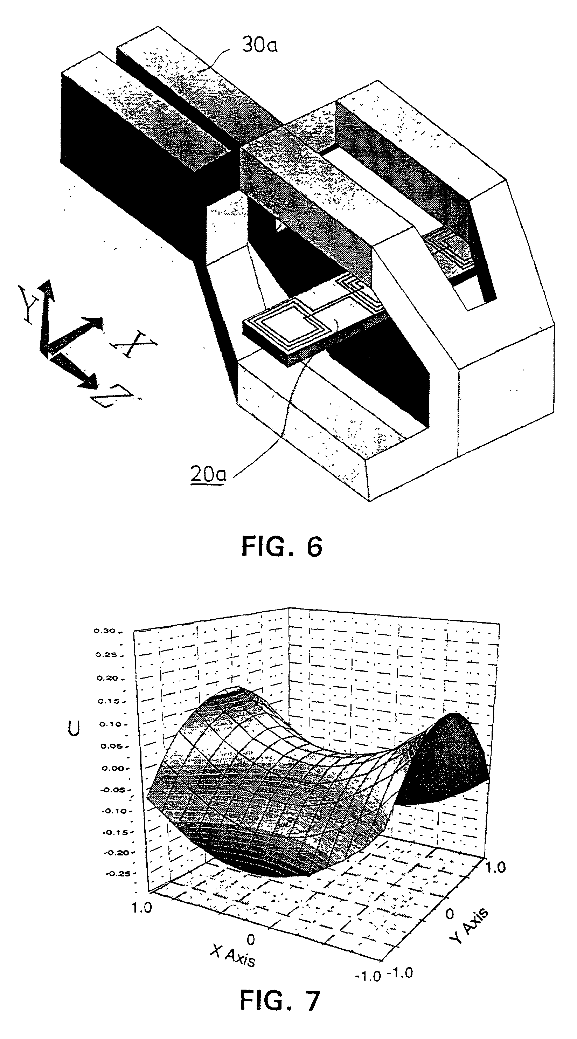

Fig. 6 is an axonometric view of a preferred embodiment of a measurement detector in accordance with the invention. Fig. 6 shows a single-phase embodiment, and the current conductor is denoted with the reference numeral 30a. In the "middle" of the current conductor 30a, a gradiometer 20a of the second order is fitted.

Fig. 7 is a graphic illustration of the way in which the output voltage U of a measurement detector as shown in Fig. 6 depends on the place of the gradiometer in relation to the X and Y axes.

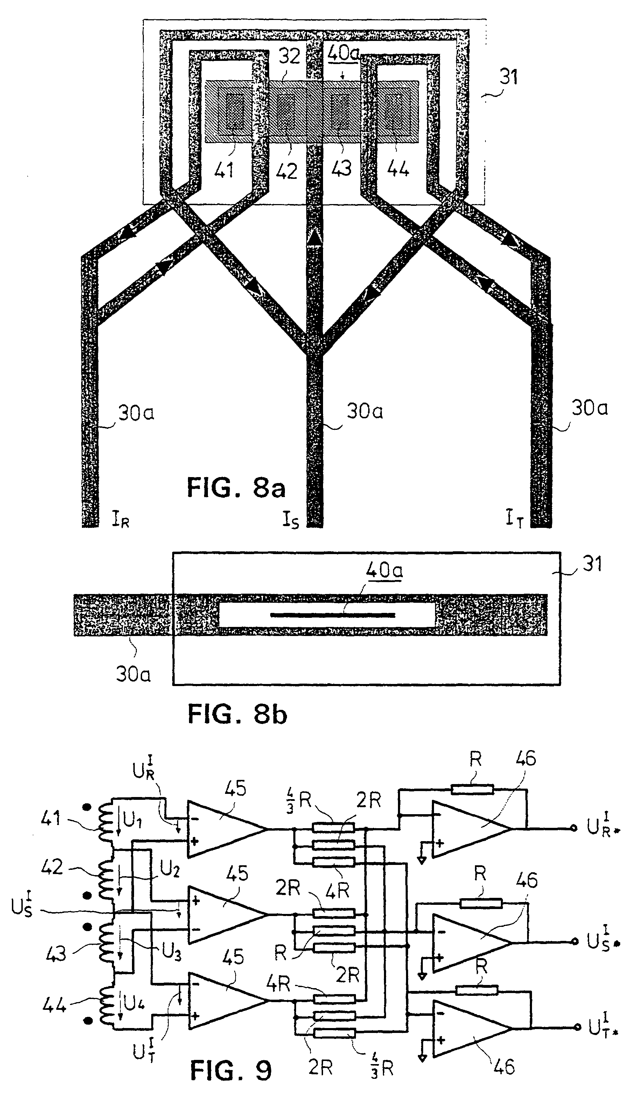

Figs. 8a and 8b are schematic illustrations of the use of a measurement detector in accordance with the present invention for measurement of three-phase current. The number of conductors 30a is three, one for each phase current $I_R, I_S$ and $I_T$. Inside the current-conductor system 30a, a gradiometer 40a of the second order is fitted, which consists of four coils 41,42,43 and 44.

A three-phase kilowatt-hour meter can be constructed, for example, by means of one microcircuit. Fig. 8a shows an arrangement in which there are four coils equal to one another as uniformly spaced. The voltages induced in the coils can be expressed by means of the phase currents $I_R$, $I_S$ and $I_T$ and of the density $B(x)$ of the outside magnetic flux as follows:

$$U_1 = \alpha I_R + \beta B(x_1)$$

$$U_2 = -\alpha I_R + \alpha I_S + \beta B(X_2)$$

$$U_3 = -\alpha I_S + \alpha I_T + \beta B(x_3)$$

$$U_4 = -\alpha I_T + \beta B(x_4)$$

wherein $\alpha$ and $\beta$ are invariables determined from the conductor and gradiometer structures.

The coils are installed in connection with one another so that the following differences are formed:

$$U_R^I = U_1 - U_2, \qquad U_S^I = -U_2 + U_3, \qquad \text{and} \qquad U_T^I = U_3 - U_4.$$

If it is assumed that the density of the outside magnetic flux is of the form

$$B(x) = B_G x + B_H,$$

what is obtained is

$$U_R^I = 2\alpha I_R - \alpha I_S + \beta B_G(x_1 - x_2),$$

$$U_S^I = -2\alpha I_S + \alpha(I_R + I_T) + \beta B_G(x_3 - x_2) \text{ and } U_T^I = 2I_T - \alpha I_S + \beta B_G(x_3 - x_4).$$

It is noticed that the homogeneous magnetic field is eliminated, but the gradient of the outside field remains. Since the coils have been fitted as uniformly spaced $\ell$, and if the origin is placed at the middle conductor, what is obtained is:

$$x_1 = -2\ell, \qquad x_2 = -\ell, \qquad x_3 = \ell \qquad \text{and} \qquad x_4 = 2\ell.$$

Now it is possible to write the voltages in the form:

$$U_R^I = 2\alpha I_R - \alpha I_S - \ell\beta B_G, \ U_S^I = -2\alpha I_S + \alpha(I_R + I_T) \text{ and } U_T^I = 2\alpha I_T - \alpha I_S + \ell\beta B_G.$$

The following voltages are formed:

$$U_{R*}^I = \tfrac{3}{4}U_R^I - \tfrac{1}{2}U_S^I + \tfrac{1}{4}U_T^I = \alpha I_R - \tfrac{1}{2}\ell\beta B_G,$$

$$U_{S*}^I = \tfrac{1}{2}U_R^I - U_S^I + \tfrac{1}{2}U_T^I = \alpha I_S$$

$$U_{T*}^I = \tfrac{1}{4}U_R^I - \tfrac{1}{2}U_S^I + \tfrac{3}{4}U_T^I = 2\alpha I_T + {}^1\!/_3\ell\beta B_G.$$

When these voltages are multiplied by the corresponding phase voltages and summed up, what is obtained is:

$$P = \alpha([I_R U_R^U] + [I_S U_S^U] + [I_T U_T^U]) - \tfrac{1}{2}\ell[\beta B_G(U_R^U - U_T^U)],$$

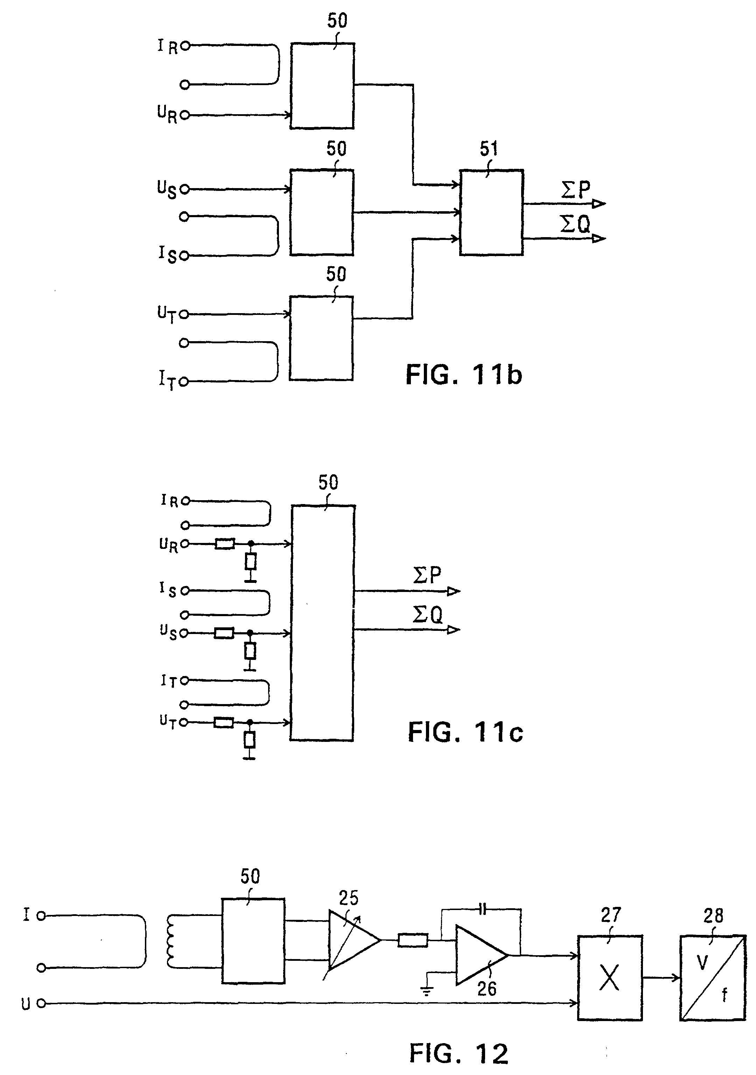

wherein [ ] means an average value. It is noticed that by means of four coils it is possible to eliminate the effect of a homogeneous field but not the effect of the gradient of an outside field. However, if the base $\ell$ of the gradiometer, i.e. the distance of the centre points of two adjacent coils from one another, is little and the connection $\alpha$ from the current conductors to the coils large, the effect of the outside field on the results remains little. The effect of an outside field can be reduced by installing a magnetic shield around the detector. Fig. 8a shows a magnetic shield 31 around the detector and an electric shield 32 between the current conductors and the other parts of the detector. The electric shield 32, which may consist, for example, of thin metal, prevents capacitive connection of the mains voltage.
Fig. 9 shows a simplified circuitry diagram of the current measurement unit of a three-phase kWh meter. The voltages $U_1, U_2, U_3$ and $U_4$ of the four coils 41,42,43 and 44 are summed together so that the effect of the homogeneous field is neutralized in the differential voltages $U_R^I$, $U_S^I$ and $U_T^I$. This is achieved by connecting the successive coils to opposite phases. Next, the outputs of the pre-amplifiers 45 are summed with one another by means of the amplifiers 46 so that three voltages $U_{R*}^I$, $U_{S*}^I$ and $U_{T*}^I$ are obtained, which are directly proportional to the phase currents. It is also possible to form differences and sums of voltages and to multiply them by a combination of the phase currents. By means of a suitable arrangement, also in this way, a situation can be produced in which exclusively terms of products of phase currents and of voltages corresponding to them are present in the overall power.

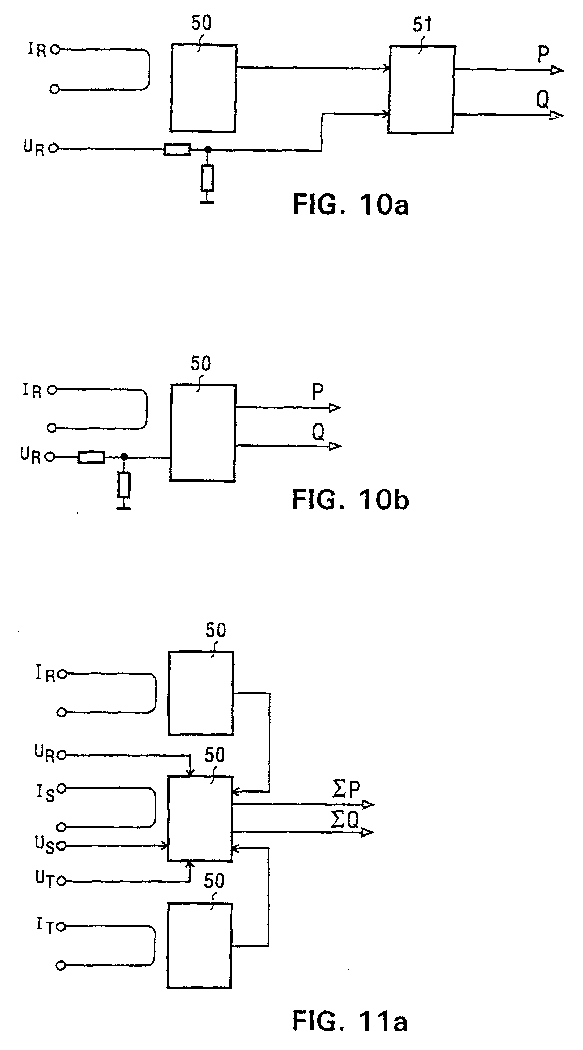

In Fig. 10a, a microcircuit in accordance with the invention contained in an integrated current detector is denoted with the reference numeral 50. The microcircuit 50 measures a single-phase phase current $I_R$, and the output of the microcircuit 50 is passed to the multiplier 51. The voltage $U_R$ of the single-phase alternating current is passed through the voltage divider to the multiplier 51. The output of the multiplier 51 is the power P or the parasitic power Q.
In the embodiment as shown in Fig. 10b, the microcircuit 50 measures a single-phase alternating current $I_R$. The voltage $U_R$ of the single-phase alternating current is passed to the microcircuit 50 likewise through the voltage divider. The output of the microcircuit 50 is directly either the power P or the parasitic power Q.
In the embodiment shown in Fig. 11a, each phase current $I_R$, $I_S$ and $I_T$ of the three-phase kWh meter is passed to act upon a separate microcircuit 50 of its own. The voltages $U_R, U_S$ and $U_T$ are passed to the middle microcircuit 50. The output of the first microcircuit 50 and the output of the third microcircuit 50 are passed to the middle microcircuit 50. The output of the middle microcircuit 50 is either $\Sigma P$ or $\Sigma Q$.
In the embodiment shown in Fig. 11b, each phase voltage $U_R$, $U_S$ and $U_T$ of the alternating current is passed to a microcircuit 50 of its own. The outputs of the microcircuits 50 are passed to the multiplier 51. The output of the multiplier 51 is either $\Sigma P$ or $\Sigma Q$.
In the embodiment shown in Fig. 11c, the three-phase kWh meter is an integrated circuit, which permits simultaneous detection of all the phase currents $I_R$, $I_S$ and $I_T$. Each phase voltage $U_R$, $U_S$ and $U_T$ of the alternating current is passed to one and the same microcircuit 50. The output of the microcircuit 50 is either $\Sigma P$ or $\Sigma Q$.
The output voltage of the current detector is directly proportional to the derivative of current in relation to time. If the shortest distance from the conductor is about 3 mm and the size of the detector shown in Fig. 3 is about 7 mm x 3 mm and the number of windings in the middle coil 21 is about 220 and the number of windings in the lateral coils 22 and 23 is about 110, the induction voltage that is obtained is about 5 µV with a current of 1A. If the noise of the amplifier is about 15 nV and the thermal noise of the resistances of the coil is about 15 nV, with an integration time constant of one second, the sensitivity becomes about 5 mA. In other words, the dynamic range of the detector can be even 5 mA ... 200 A. The maximal value of current is determined mainly by the heating of the conductor. The amplifier can either have a fixed amplification, or the amplification can be made adjustable. After the amplifier 25, an integrator 26 can be added to the microcircuit 50, the phase of the output voltage of said integrator 26 being the same as the phase of the current to be measured. Such a solution is illustrated in Fig. 12.

As is shown in Fig. 12, in connection with the current detector in accordance with the invention, an additional amplifier 25, an integrator 26, a multiplier 27, and a voltage-frequency converter 28 can be integrated. Thus, all the parts of the kWh meter can be integrated in the same microcircuit. The voltage can be monitored either directly from the microcircuit 50 capacitively or by feeding the voltage through a resistor to the microcircuit 50. The current detector permits integration of the whole kWh meter in one microcircuit 50. In principle, a three-phase kWh meter requires three separate microcircuits 50. It is also possible to manufacture a long, for example (8...14 mm) and thin (3...4 mm) integrated circuit 50, which permits simultaneous detection of all the phase currents. This permits the manufacture of a highly advantageous three-phase kWh meter.

Above, just some preferred embodiments of the invention have been described, and it is obvious to a person skilled in the art that numerous modifications can be made to said embodiments within the scope of the accompanying patent claims.

The invention concerns a method for measurement of alternating current, a measurement detector meant for measurement of alternating current, and the use of such a measurement detector in a kWh meter. In the method, inside the current conductor system (30a) or in direct vicinity of said system, a gradiometer of at least the first order is fitted, in which case the current that flows in the current conductor system (30a) induces a voltage in the gradiometer, and that the shape of the current conductor system (30a) and the shape of the coil construction of the gradiometer (20a) are adapted to one another so that the output signal is substantially independent from any little changes taking place in the relative positions of the current conductor system (30a) and the gradiometer (20a).

## Claims

1.  A method of measuring an alternating current, wherein inside a current conductor system (**30,30a**) or in direct vicinity of said system, a gradiometer of at least the first order is fitted, such that the current flowing in the current conductor system (**30, 30a**) induces a voltage in the gradiometer, and wherein the shape of the current conductor system (**30,30a**) and the shape of the coil construction (**21,22,23**) of the gradiometer (**20a**) are adapted to one another so that the output signal is substantially independent from any little changes taking place in the relative positions of the current conductor system (**30, 30a**) and the gradiometer (**20a**).

2.  A method as claimed in claim 1, wherein a gradiometer of the first order is used as the gradiometer.

3.  A method as claimed in claim 1, wherein a gradiometer (**20a**) of the second order is used as the gradiometer.

4.  A method as claimed in claim 1, wherein a gradiometer of the $n^{th}$ order is used as the gradiometer, wherein n is 3,4,5 or 6.

5.  An integrated current detector for measurement of alternating current, wherein the current detector consists of a current conductor system (**30,30a**) and of a gradiometer (**20a**) fitted inside or in direct vicinity of said conductor system, and wherein a pre-amplifier/pre-amplifiers is/are fitted in direct vicinity of the outputs of the gradiometer.

6.  A current detector as claimed in claim 5, wherein the coils of the gradiometer (**20a**) of at least the second order consist of at least three coils (**21,22,23**), the areas of which are equal but in which the number of windings in the middle coil (**21**) is twice as high as the number of windings in the lateral coils (**22,23**).

7.  A current detector as claimed in claim 6, wherein the number of windings in the middle coil (**21**) is in a range of 10...1000.

8.  A current detector as claimed in claim 5 or 7, wherein the areas of the coils (**21,22,23**) are in a range of 1...30 $mm^2$.

9.  A current detector as claimed in any of the claims 5 to 8, wherein, in the current detector, an additional amplifier (**25**), an integrator (**26**), a multiplier (**27**), and a voltage-frequency converter (**28**) have been fitted.

**10.** A current detector as claimed in any of the claims 5 to 9, wherein the current conductor (**30**) is made from a rectangular conductor which has been split at both ends, the current-conductor construction producing a magnetic distribution of parabolic form in the middle of the current conductor such that a flux density (**By**) shows a parabolic dependence on displacements in a plane situated in the middle of the conductor and having a direction which is parallel to the direction of the longitudinal axis of the conductor.

**11.** A current detector as claimed in any of the claims 5 to 10, wherein between the current conductor and the other parts of the detector, there is an electric shield (**32**).

**12.** A current detector as claimed in any of the claims 5 to 11, wherein a magnetic shield (**31**) has been fitted around the detector.

**13.** A current detector as claimed in any of the claims 5 to 12, wherein the dynamic range of the current detector is in the range of 5 mA ... 200 A.

**14.** The use of a current detector as claimed in any of the claims 5 to 13 in a single-phase kWh meter.

**15.** A three-phase kWh meter in which each phase current (**IR, IS, IT**) is coupled to a separate current detector as claimed in any of the claims 5 to 13,
    each current detector comprising a microcircuit (**50**),
    each microcircuit comprising at least one gradiometer of the associated current detector.

**16.** A kWh meter in which there is a current detector as claimed in any of the claims 5 to 13, wherein the three-phase kWh meter is an integrated microcircuit (**50**) which permits simultaneous detection of all the phase currents ($I_R$,$I_S$, $I_T$), the microcircuit (**50**) comprising at least one gradiometer.

**17.** A kWh meter as claimed in claims 15 or 16, wherein the gradiometer (**40a**) of the second order consists of four coils (**41,42,43,44**), and wherein successive coils, the signals of which are to be summed up, are connected to opposite phases, whereby the effect of a homogeneous field is neutralized.

**Patentansprüche**

**1.** Verfahren zum Messen eines Wechselstroms, wobei in einem Stromleitersystem (30, 30a) oder in direkter Nähe des Systems ein Gradiometer zumindest der ersten Ordnung angebracht ist, so daß der in dem Stromleitersystem (30, 30a) fließende Strom in dem Gradiometer eine Spannung induziert, und wobei die Form des Stromleitersystems (30, 30a) und die Form der Spulenkonstruktion (21, 22, 23) des Gradiometers (20a) aneinander angepaßt sind, so daß das Ausgangssignal im wesentlichen unabhängig von kleinen Änderungen ist, die hinsichtlich der relativen Positionen des Stromleitersystems (30, 30a) und des Gradiometers (20a) auftreten.

**2.** Verfahren nach Anspruch 1, wobei ein Gradiometer erster Ordnung als das Gradiometer verwendet wird.

**3.** Verfahren nach Anspruch 1, wobei ein Gradiometer (20a) zweiter Ordnung als das Gradiometer verwendet wird.

**4.** Verfahren nach Anspruch 1, wobei ein Gradiometer n-ter Ordnung als das Gradiometer verwendet wird, wobei n gleich 3, 4, 5 oder 6 ist.

**5.** Integrierte Stromerfassungseinrichtung zur Messung eines Wechselstroms, wobei die Stromerfassungseinrichtung ein Stromleitersystem (30, 30a) und ein in oder in direkter Nähe zu dem Leitersystem angebrachtes Gradiometer beinhaltet, und wobei eine Vorverstärkungseinheit/Vorverstärkungseinheiten in direkter Nähe zu den Ausgängen des Gradiometers angebracht ist/sind.

**6.** Stromerfassungseinrichtung nach Anspruch 5, wobei die Spulen des Gradiometers (20a) zumindest der zweiten Ordnung aus zumindest drei Spulen (21, 22, 23) bestehen, wobei ihre Flächen gleich sind, wobei bei ihnen jedoch die Zahl der Wicklungen der mittleren Spule (21) zweimal so hoch wie die Zahl der Wicklungen der Seitenspulen (22, 23) ist.

**7.** Stromerfassungseinrichtung nach Anspruch 6, wobei die Zahl der Wicklungen der mittleren Spule (21) in einem Bereich von 10 ... 1000 liegt.

8. Stromerfassungseinrichtung nach Anspruch 5 oder 7, wobei die Flächen der Spulen (21, 22, 23) in einem Bereich von 1...30 mm$^2$ liegen.

9. Stromerfassungseinrichtung nach einem der Ansprüche 5 bis 8, wobei an der Stromerfassungseinrichtung eine zusätzliche Verstärkungseinheit (25), eine Integriereinheit (26), eine Multipliziereinheit (27) und eine Spannungs-Frequenz-Wandlungseinheit (28) angebracht worden sind.

10. Stromerfassungseinrichtung nach einem der Ansprüche 5 bis 9, wobei der Stromleiter (30) aus einem rechtwinkligen Leiter hergestellt ist, der an beiden Enden gespalten worden ist, die Stromleiterkonstruktion eine magnetische Verteilung in parabolischer Form in der Mitte des Stromleiters erzeugt, so daß eine Flußdichte (By) eine parabolische Abhängigkeit von Verschiebungen zeigt, die in einer in der Mitte des Leiters angeordneten Ebene vorgesehen sind und eine Richtung aufweisen, die parallel zu der Richtung der Längsachse des Leiters ist.

11. Stromerfassungseinrichtung nach einem der Ansprüche 5 bis 10, wobei zwischen dem Stromleiter und den weiteren Teilen der Erfassungseinrichtung eine elektrische Abschirmung (32) vorgesehen ist.

12. Stromerfassungseinrichtung nach einem der Ansprüche 5 bis 11, wobei eine magnetische Abschirmung (31) um die Erfassungseinrichtung herum angebracht worden ist.

13. Stromerfassungseinrichtung nach einem der Ansprüche 5 bis 12, wobei der dynamische Bereich der Stromerfassungseinrichtung in dem Bereich von 5 mA ... 200 A liegt.

14. Verwendung einer Stromerfassungseinrichtung nach einem der Ansprüche 5 bis 13 an einer Einphasen-kWh-Meßvorrichtung.

15. Dreiphasen-kWh-Meßvorrichtung, bei der ein jeder Phasenstrom (IR, IS, IT) mit einer separaten Stromerfassungseinrichtung nach einem der Ansprüche 5 bis 13 gekoppelt ist,
    wobei eine jede Stromerfassungseinrichtung eine Mikroschaltung (50) aufweist,
    wobei jede Mikroschaltung zumindest ein Gradiometer der zugeordneten Stromerfassungseinrichtung aufweist.

16. KWh-Meßvorrichtung, bei der eine Stromerfassungseinrichtung nach einem der Ansprüche 5 bis 13 vorhanden ist, wobei die Dreiphasen-kWh-Meßvorrichtung einer integrierten Mikroschaltung (50) entspricht, die eine gleichzeitige Erfassung von allen den Phasenströmen ($I_R$, $I_S$, $I_T$) zuläßt, wobei die Mikroschaltung (50) zumindest ein Gradiometer aufweist.

17. KWh-Meßvorrichtung nach einem der Ansprüche 15 oder 16, wobei das Gradiometer (40a) der zweiten Ordnung aus vier Spulen (41, 42, 43, 44) besteht, und wobei aufeinanderfolgende Spulen, deren Signale aufzusummieren sind, mit entgegengesetzten Phasen verbunden sind, wodurch der Effekt eines homogenen Feldes neutralisiert ist.

**Revendications**

1. Procédé de mesure d'un courant alternatif dans lequel, à l'intérieur d'un système conducteur de courant (30, 30a) ou au voisinage direct dudit système, est inséré un instrument à mesurer les gradients d'au moins du premier ordre, de sorte que le courant passant dans le système conducteur de courant (30, 30a) induit une tension dans l'instrument à mesurer les gradients, et dans lequel la forme du système de conducteur de courant (30, 30a) et la forme de la construction de bobine (21, 22, 23) de l'instrument à mesurer les gradients (20a) sont adaptées l'une à l'autre pour que le signal de sortie soit sensiblement indépendant de toutes petites variations ayant lieu dans les positions relatives du système conducteur de courant (30, 30a) et de l'instrument à mesurer les gradients (20a).

2. Procédé selon la revendication 1, dans lequel un instrument à mesurer les gradients du premier ordre est utilisé comme instrument à mesurer les gradients.

3. Procédé selon la revendication 1, dans lequel un instrument à mesurer les gradients (20a) du second ordre est utilisé comme instrument à mesurer les gradients.

**4.** Procédé selon la revendication 1, dans lequel l'instrument à mesurer les gradients du n$^{ième}$ ordre est utilisé comme instrument à mesurer les gradients, dans lequel n est 3, 4, 5 ou 6.

**5.** Détecteur de courant intégré pour la mesure d'un courant alternatif, dans lequel le détecteur de courant se compose d'un système conducteur de courant (30, 30a) et d'un instrument à mesurer les gradients (20a) inséré à l'intérieur ou au voisinage direct dudit système conducteur, et où un préamplificateur/des préamplificateurs est/sont insérés au voisinage direct des sorties de l'instrument à mesurer les gradients.

**6.** Détecteur de courant selon la revendication 5, dans lequel les bobines de l'instrument à mesurer les gradients (20a) d'au moins du second ordre se composent d'au moins trois bobines (21, 22, 23), dont les zones sont égales mais dans lesquelles le nombre d'enroulements dans la bobine du milieu (21) est deux fois plus élevé que le nombre d'enroulements dans les bobines latérales (22, 23).

**7.** Détecteur de courant selon la revendication 6, dans lequel le nombre d'enroulements dans la bobine de milieu (21) est dans une gamme de 10 à 1000.

**8.** Détecteur de courant selon la revendication 5 ou 7, dans lequel les zones de bobine (21, 22, 23) sont dans une gamme de 1 à 30 mm$^2$.

**9.** Détecteur de courant selon l'une quelconque des revendications 5 à 8, dans lequel, dans le détecteur de courant, un amplificateur supplémentaire (25), un intégrateur (26), un multiplieur (27), et un convertisseur de tension-fréquence (28) ont été insérés.

**10.** Détecteur de courant selon l'une quelconque des revendications 5 à 9, dans lequel le détecteur de courant (30) est fait d'un conducteur rectangulaire qui a été divisé aux deux extrémités, la construction du conducteur de courant produisant une distribution magnétique de forme parabolique au milieu du conducteur de courant de sorte qu'une densité de flux (By) montre une dépendance parabolique sur des déplacements dans un plan situé au milieu du conducteur et ayant une direction qui est parallèle à la direction de l'axe longitudinal du conducteur.

**11.** Détecteur de courant selon l'une quelconque des revendications 5 à 10, dans lequel entre le conducteur de courant et les autres parties du détecteur, il y a un blindage électrique (32).

**12.** Détecteur de courant selon l'une quelconque des revendications 5 à 11, dans lequel un blindage magnétique (31) a été ajouté autour du détecteur.

**13.** Détecteur de courant selon l'une quelconque des revendications 5 à 12, dans lequel la plage dynamique du détecteur de courant est dans la gamme de 5 mA à 200 A.

**14.** Utilisation d'un détecteur de courant selon l'une quelconque des revendications 5 à 13 dans un compteur de kilowattheure monophasé.

**15.** Compteur de kilowattheure triphasé dans lequel chaque courant de phase ($I_R$, $I_S$, $I_T$) est couplé à un détecteur de courant séparé comme revendiqué dans l'une quelconque des revendications 5 à 13,
chaque détecteur de courant comprenant un microcircuit (50),
chaque microcircuit comprenant au moins un instrument à mesurer les gradients du détecteur de courant associé.

**16.** Compteur de kilowattheure dans lequel il y a un détecteur de courant selon l'une quelconque des revendications 5 à 13, dans lequel le compteur de kilowattheure triphasé est un microcircuit intégré (50) qui permet la détection simultanée de tous les courants de phase ($I_R$, $I_S$, $I_T$), le microcircuit (50) comprenant au moins un instrument à mesurer les gradients.

**17.** Compteur de kilowattheure selon la revendication 15 ou 16, dans lequel l'instrument à mesurer les gradients (40a) du second ordre se compose de quatre bobines (41, 42, 43, 44) et où des bobines successives, dont les signaux sont ajoutés, sont raccordées à des phases opposées, de sorte que l'effet d'un champ homogène est neutralisé.

FIG. 1

PRIOR ART

FIG. 2

PRIOR ART

**FIG. 3**

**FIG. 4**

**FIG. 5**

FIG. 6

FIG. 7

FIG. 8a

FIG. 8b

FIG. 9

FIG. 10a

FIG. 10b

FIG. 11a

**FIG. 11b**

**FIG. 11c**

**FIG. 12**